**Europäisches Patentamt**

**European Patent Office**

**Office européen des brevets**

(19)

(11) Veröffentlichungsnummer: **0 150 365**
**B1**

(12) # EUROPÄISCHE PATENTSCHRIFT

(45) Veröffentlichungstag der Patentschrift:
**12.10.88**

(21) Anmeldenummer: **84115076.6**

(22) Anmeldetag: **10.12.84**

(51) Int. Cl.⁴: **H 01 L 29/08,** H 01 L 29/78, H 01 L 29/74

(54) **Halbleiterbauelement mit Kontaktloch.**

(30) Priorität: **27.01.84 DE 3402867**

(43) Veröffentlichungstag der Anmeldung:
**07.08.85 Patentblatt 85/32**

(45) Bekanntmachung des Hinweises auf die Patenterteilung:
**12.10.88 Patentblatt 88/41**

(84) Benannte Vertragsstaaten:
**AT CH DE FR GB IT LI NL**

(56) Entgegenhaltungen:
**EP-A-0 038 994**

**IEEE TRANSACTIONS ON ELECTRON DEVICES, Band ED-18, Nr. 8, August 1971, Seiten 525-527, New York, US; B.T. JOHNSON: "The Epi channel switch"**
**INTERNATIONAL ELECTRON DEVICES MEETING, 13.-15. Dezember 1982, San Francisco, US, Seiten 246-249, IEEE, US; H. IKEDA et al.: "High-frequency, high-power MOS-FET"**

(73) Patentinhaber: **Siemens Aktiengesellschaft Berlin und München, Wittelsbacherplatz 2, D-8000 München 2 (DE)**

(72) Erfinder: **Franz, Günther, Dr. Dipl.- Phys., Flensburger Strasse 14, D-8000 München 81 (DE)**

## Beschreibung

Die Erfindung bezieht sich auf ein Halbleiterbauelement mit den Merkmalen:

a) An einer der Oberflächen eines Halbleiterkörpers 1 ist eine erste Zone vom ersten Leitungstyp angeordnet,

b) in die erste Zone ist eine zweite Zone vom zweiten Leitungstyp eingebettet,

c) die zweite Zone ist mit einer Öffnung versehen,

d) die erste Zone hat unter dieser Öffnung eine freiliegende, von der zweiten Zone unbedeckte Fläche,

e) erste und zweite Zone sind durch einen aus Aluminium bestehenden ohmschen Kontakt elektrisch miteinander verbunden.

Ein solches Halbleiterbauelement ist beispielsweise in der EP-38 994 A3 beschrieben worden. Die erste Zone dieses Halbleiterbauelements ist stark p-dotiert, während die in die erste Zone eingebettete zweite Zone schwach n-dotiert ist. Ein ohmscher Kontakt zwischen der schwach n-dotierten Zone und dem Aluminiumkontakt wird dadurch erzielt, daß die stark p-dotierte erste Zone eine Vertiefung aufweist, die durch den Aluminiumkontakt kontaktiert ist. Zwischen der Vertiefung und der schwach n-dotierten Zone ist eine stark n-dotierte Zone angeordnet, die einerseits die schwach n-dotierte Zone und andererseits den Aluminiumkontakt kontaktiert. Auf diese Weise wird ein ohmscher Kontakt zwischen dem Aluminiumkontakt und der schwach n-dotierten Zone erreicht.

Diese Lösung ist für Halbleiterbaulemente mit der umgekehrten Zonenfolge, z. B. für p-Kanal-MOSFET nicht verwendbar, da ein ohmscher Kontakt zu n-dotiertem Silicium voraussetzt, daß die n-dotierte Zone sehr hoch dotiert wird, z. B. $10^{19}$ Atome cm$^{-3}$.

Wird dann in die (erste) n-dotierte Zone die (zweite) p-dotierte Zone eingebettet, so bedeutet dies, daß die p-dotierte noch höher dotiert werden muß, um ein Umdotieren gegenüber der n-dotierten Zone zu erreichen.

Der Erfindung liegt die Aufgabe zugrunde, ein Halbleiterbauelement der genannten Art so weiterzubilden, daß ein ohmscher Kontakt der n-dotierten Zone mit einer Aluminiumschicht erreicht wird, ohne daß die eingebettete p-leitende Zone höher dotiert werden muß, als es die elektrischen Eigenschaften des Halbleiterbauelements erfordern.

Die Erfindung ist gekennzeichnet durch die Merkmale:

f) die erste Zone ist n-leitend,

g) die zweite Zone ist p-leitend,

h) in der freiliegenden Fläche der ersten Zone ist eine n-leitende Schicht mit einer Implantationsdosis von mindestens 5 X $10^{14}$ Atomen cm$^{-2}$ eingebettet,

i) der Kontakt kontaktiert die erste Zone an der genannten Schicht.

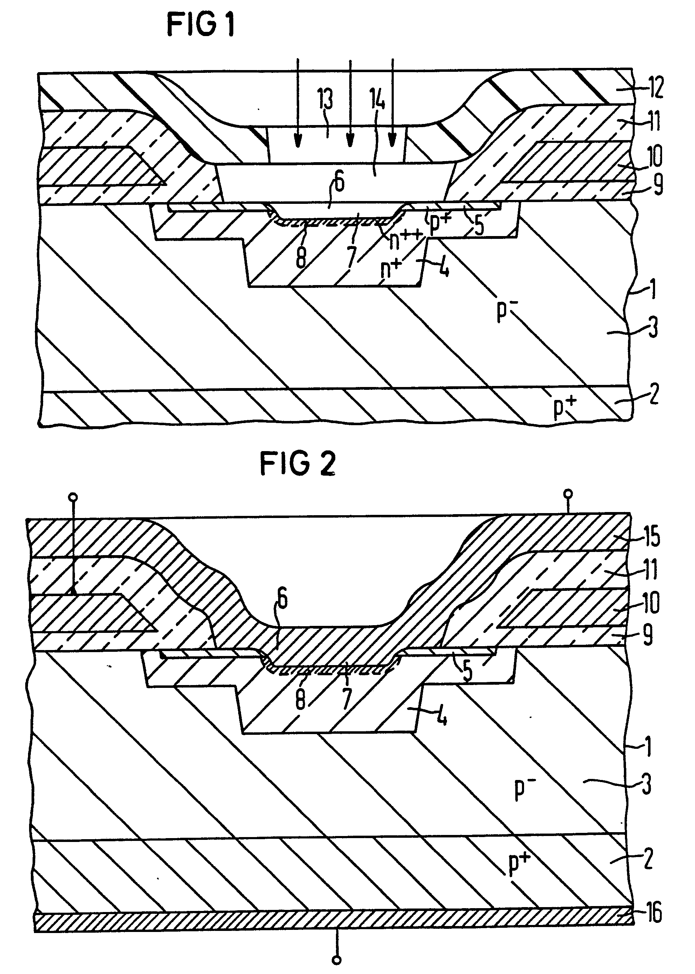

Weiterbildungen und ein Verfahren zum Herstellen eines solchen Halbleiterbauelements sind Gegenstand der Unteransprüche. Die Erfindung wird anhand der FIG 1 und 2 näher erläutert. Es zeigen:

FIG 1 einen Schnitt durch das Halbleiterbauelement während eines charakteristischen Verfahrensschrittes,

FIG 2 einen Schnitt durch das fertige, kontaktierte Halbleiterbauelement.

Das Halbleiterbauelement hat einen Halbleiterkörper 1. Der Halbleiterkörper 1 besteht aus einem hoch p-dotiertem Substrat 2, auf dem eine niedrig p-dotierte Schicht 3, beispielsweise eine Epitaxieschicht, angeordnet ist. In die Oberfläche des Halbleiterkörpers 1, d. h. in die Schicht 3, ist eine erste Zone 4 eingebettet. Diese ist stark n-leitend. Die Zone 4 kann, wie gezeigt, in der Mitte größere Dicke als außen haben. Dann wird der Mittelteil auf bekannte Weise eindiffundiert und der äußere, dünnere Teil z. B. durch Ionenimplantation und anschließendes Eintreiben erzeugt. Die Zone 4 kann auch eine konstante Dicke haben und wird dann alleine durch Ionenimplantation und anschließendes Eintreiben gebildet. Auf die Oberfläche der Schicht 3 und der ersten Zone 4 wird eine erste Oxidschicht 9 aufgebracht, die aus Siliciumdioxid besteht, wenn der Halbleiterkörper Silicium ist. Auf die erste Oxidschicht 9 wird in bestimmten vorgegebenen Bereichen eine Schicht 10 aus polykristallinem Silicium aufgebracht. Dies kann durch ganzflächiges Aufbringen und strukturiertes Ätzen geschehen. Die polykristalline Siliciumschicht 10 dient in bekannter Weise als Maske für die Implantation der zweiten Zone 5 und als Gateelektrode für den p-Kanal-MOSFET. Die zweite Zone 5 wird beispielsweise durch Implantation von Borionen hergestellt. Die Implantationsdosis beträgt beispielsweise 2 · $10^{15}$ Atome cm$^{-2}$. Ihre Dicke kann bei 0,5 µm liegen. Die Orientierung der zweiten Zone 5 zur ersten Zone 4 ist derart, daß sich an der Oberfläche der Schicht 3 p-Kanäle de gewünschten Länge ergeben.

Als nächstes wird auf die erste Oxidschicht 9 und die polykristalline Siliciumschicht 10 eine zweite Oxidschicht 11 aufgebracht. Diese Schicht 11 wird dann mit einer Fotolackschicht 12 überzogen. In der Fotolackschicht 12 wird eine Öffnung 13 erzeugt. Durch die Öffnung wird die Oberfläche im Bereich der Zone 5 bzw. der Oberfläche des Halbleiterkörpers isotrop naßgeätzt, bis eine Unterätzung der Lackmaske erreicht ist. Damit werden die Oxidschichten 9, 11 geöffnet; die Öffnung ist mit 14 bezeichnet. Die Ätzung wird zweckmäßigerweise dann abgebrochen, wenn ein Teil der Oberfläche der zweiten Zone 5 freiliegt.

Anschließend wird die Lackmaske 12 dazu verwendet, in die zweite Zone 5 eine Öffnung 6 zu ätzen. Hierfür wird ein (anisotropes) Plasmaätzverfahren z. B. mit Schwefelhexafluorid $SF_6$ benutzt. Das Plasma wird in Richtung der Pfeile durch die Öffnung 13 der Lackmaske 12 auf die Oberfläche der Zone 5 gerichtet. Der Plasmaätzvorgang kann wahlweise weitergeführt werden, bis in die erste Zone 4 eine Vertiefung 7 eingeätzt ist. Unbedingt notwendig ist dies jedoch nicht. Wesentlich ist jedoch, daß die Zone 4 eine nach oben freiliegende Fläche erhält.

Anschließend an das Freilegen der Oberfläche der ersten Zone 4 wird die freiliegende Oberfläche der ersten Zone 4 durch Ionenimplantation z. B. mit Phosphor dotiert. Hierbei entsteht eine hoch n-leitende Schicht 8, die entweder eben ausgebildet oder im Fall einer vorherigen Erzeugung der vertiefung 7 durch Wand und Boden der Vertiefung gebildet wird. Die Dotierung erfolgt mit einer Dosis von $\geqslant 5 \cdot 10^{14}$ cm$^{-2}$ bei einer Energie von beispielsweise 30 keV. Dies entspricht bei einer Dicke von z. B. 0,1 um einer maximalen Dotierung von ca. $1 \cdot 10^{20}$ Atome cm$^{-3}$.

Nach Entfernen der Lackmaske 12 wird das Halbleiterbauelement mit einer Aluminiumschicht 15 bedeckt, die die Zonen 4 und 5 kontaktiert. Der andere Kontakt (Drainkontakt) ist beispielsweise auf der Unterseite des Halbleiterkörpers 1 angebracht und mit 16 bezeichnet. Um einen optimalen Kontakt zwischen der Aluminiumschicht 15 und der ersten Zone 4 zu erreichen, empfiehlt es sich, die durch die Ionenimplantation erzeugten Kristallschäden in der hoch n-leitenden Zone 8 nicht zu beseitigen.

Die Erfindung wurde in Verbindung mit einem p-Kanal-MODFET beschreiben. Die Kontaktierung der ersten Zoneund der Zweiten Zone 5 durch einen einzigen Kontakt hat den Zweck, einen Nebenschluß zwischen diesen Zonen herzustellen. Damit werden die Eigenschaften der im MOSFET enthaltenen, durch die Zonen 3 und 4 gebildeten Inversdiode verbessert. Die Erfindung ist auch z. B. bei bipolaren Halbleiterbauelementen anwendbar, wenn eine p-dotierte Zone und eine darunterliegende n-dotierte Zone durch den gleichen Kontakt kontaktiert werden sollen und die obenliegende p-dotierte Schicht nicht mehr fehlerfrei gebildet werden kann, wenn eine für einen einwandfreien ohmschen Kontakt ausreichende Dotierung in der darunterliegenden n-dotierten Zone vorhanden ist.

**Patentansprüche**

1. Halbleiterbauelement mit den Merkmalen:

a) An einer der Oberflächen eines Halbleiterkörpers (1) ist eine erste Zone (4) vom ersten Leitungstyp angeordnet,

b) in die erste Zone (4) ist eine zweite Zone (5) vom zweiten Leitungstyp eingebettet,

c) die zweite Zone (5) ist mit einer Öffnung (6) versehen,

d) die erste Zone (4) hat unter dieser Öffnung (6) eine freiliegende, von der zweiten Zone (5) unbedeckte Fläche,

e) erste und zweite Zone sind durch einen aus Aluminium bestehenden ohmschen Kontakt (15) elektrisch miteinander verbunden, gekennzeichnet durch die Merkmale :

f) die erste Zone (4) ist n-leitend,

g) die zweite Zone (5) ist p-leitend,

h) in der freiliegenden Fläche der ersten Zone (4) ist eine n-leitende Schicht (8) mit einer Implantationsdosis von mindestens $5 \times 10^{14}$ Atomen cm$^{-2}$ eingebettet,

i) der Kontakt (15) kontaktiert die erste Zone (4) an der genannten Schicht (8).

2. Halbleiterbauelement nach Anspruch 1, dadurch gekennzeichnet, daß die n-leitende Schicht (8) etwa 0,1 μm dick ist.

3. Halbleiterbauelement nach Anspruch 1 oder 2, dadurch gekennseichnet, daß die n-leitende Schicht (8) an der Oberfläche einer in der ersten Schicht (4) vorgesehenen Vertiefung (7) sitzt.

4. Verfahren zum Herstellen eines Halbleiterbauelements nach einen der Ansprüche 1 bis 3, gekennzeichnet durch die Schritte:

a) In der Oberfläche des Halbleiterkörpers wird die erste Zone (4) erzeugt und die Oberfläche des Halbleiterkörpers wird mit einer ersten Oxidschicht (9) bedeckt,

b) auf die erste Oxidschicht (9) wird in einem vorgegebenen Bereich eine Schicht (10) aus polykristallinem Silicium aufgebracht,

c) in der Oberfläche der ersten Zone (4) wird die zweite Zone (5) unter Verwendung der polykristallinen Siliciumschicht (10) als Maske durch Ionenimplantation erzeugt,

d) die erste Oxidschicht (9) und die polykristalline Siliciumschicht (10) werden mit einer zweiten Oxidschicht (11) bedeckt,

e) die zweite Oxidschicht (11) wird mit einer Lackmaske (12) bedeckt , deren Öffnung (13) über der zweiten Zone (5) liegt,

f) die Oxidschichten (9, 11) werden isotrop geätzt , bis die Lackmaske (12) unterätzt ist und ein Teil der Oberfläche der zweiten Zone (5) freiliegt,

g) die Oberfläche des Halbleiterkörpers wird durch die gleiche Öffnung (13) der Lackmaske (12) plasmageätzt, bis in der zweiten Zone (5) die Öffnung (6) und in der ersten Zone (4) die Vertiefung (7) gebildet ist,

h) die n-leitende Schicht (8) wird unter Verwendung der Lackmaske (12) und deren Öffnung (13) durch Ionenimplantation mit einer Dosis $\geqslant 5 \cdot 10^{14}$ Atomen cm$^{-2}$ erzeugt,

i) die Lackmaske wird abgelöst,

j) die freiliegenden Flächen der ersten und zweiten Zone werden mit einer Aluminiumschicht (15) versehen.

## Claims

1. A semiconductor component comprising the following features:

a) a first zone (4) of the first conductivity type is arranged on one of the surfaces of a semiconductor body (1),

b) a second zone (5) of the second conductivity type is embedded into the first zone (4),

c) the second zone (5) is provided with an opening (6),

d) beneath this opening (6) the first zone (4) has an exposed area which is not covered by the second zone (5),

e) the first and second zones are electrically connected to one another by an ohmic contact (15) made of aluminium, characterised by the following features:

f) the first zone (4) is n-conducting,

9) the second zone (5) is p-conducting,

h) in the exposed surface area of the first zone (4) there is embedded an n-conducting layer (8) with an implantation dose of at least $5 \cdot 10^{14}$ atoms cm$^{-2}$,

i) the contact (15) contacts the first zone (4) at the location of the said layer (8).

2. A semiconductor component as claimed in Claim 1, characterised in that the thickness of the n-conducting layer (8) is about 0,1 μm.

3. A semiconductor component as claimed in Claim 1 or 2, characterised in that the n-conducting layer (8) is arranged on the surface of a recess (7) provided in the first layer (4).

4. A process for the production of a semiconductor component as claimed in one of Claims 1 to 3, characterised by the following steps:

a) the first zone (4) is produced in the surface of the semiconductor body, and the surface of the semiconductor body is covered with a first oxide layer (9),

b) a layer (10) of polycrystalline silicon is applied to the first oxide layer (9) in a predetermined area,

c) the second zone (5) is produced by ion implantation in the surface of the first zone (4) using the polycrystalline silicon layer (10) as mask,

d) the first oxide layer (9) and the polycrystalline silicon layer (10) are covered with a second oxide layer (11),

e) the second oxide layer (11) is covered with a photo-resist mask (12) whose opening (13) is located above tiie second zone (5),

f) the oxide layers (9, 11) are etched isotropically until the photo-resist mask (12) is under-etched and a part of the surface of the second zone (5) is exposed,

g) the surface of the semiconductor body is plasma-etched through the same opening (13) in the photo-resist mask (12) until the opening (6) is formed in the second zone (5) and the recess (7) is formed in the first zone (4),

h) the n-conducting layer (8) is formed by ion implantation, using the photo-resist mask (12) and its opening (13), with a dose of $5 \cdot 10^{14}$ atoms cm$^{-2}$,

i) the photo-resist mask is removed,

j) the exposed surface areas of the first and second zones are provided with an aluminium layer (15).

## Revendications

1. Composant à semiconducteurs présentant les caractéristiques suivantes:

a) une première zone (4) possédant un premier type de conductivité est ménagée dans l'une des surfaces d'un corps semiconducteur (1),

b) une seconde zone (5) possédant le second type de conductivité est insérée dans la première zone (4),

c) la seconde zone (5) comporte une ouverture (6),

d) la première zone (4) possède, au-dessous de cette ouverture (6), une surface à nu, non recouverte par la seconde zone (5),

e) les première et seconde zones sont réunies électriquement entre elles par un contact ohmique (15) réalisé en aluminium, remarquable par les caractéristiques:

f) la première zone (4) est conductrice du type n,

g) la seconde zone (5) est conductrice du type p,

h) une couche (8) conductrice du type n et possédant une dose d'implantation d'au moins $5 \cdot 10^{14}$ atomes cm$^{-2}$ est insérée dans la surface a nu de la première zone (4),

i) le contact (15) touche la première zone (5) au niveau de ladite couche (8).

2. Composant à semiconducteurs suivant la revendication 1, caractérisé par le fait que la couche (8) conductrice de type n possède une épaisseur d'environ 0,1 μm.

3. Composant à semiconducteurs suivant la revendication 1 ou 2, caractérisé par le fait que la couche (8) du type n est appliquée sur une surface d'un renfoncement (7) prévu dans la première couche (4).

4. Procédé pour fabriquer un composant à semiconducteurs suivant l'une des revendications 1 à 3, caractérisé par les étapes opératoires consistant à:

a) on forme la première zone (4) dans la surface du corps semiconducteur et on recouvre la surface du corps semiconducteur par une première couche d'oxyde (9),

b) on dépose une couche (10) de silicium polycristallin dans une zone prédéterminée sur la première couche d'oxyde (9),

c) on réalise la seconde zone (5) par implantation ionique, moyennant l'utilisation de la couche de silicium polycristallin (10), dans la surface de la première zone (4),

d) on recouvre la première couche d'oxyde (9) et la couche de silicium polycristallin (10) par une seconde couche d'oxyde (11),

e) on recouvre la seconde couche d'oxyde (11) par un masque de laque (12), dont l'ouverture (13) est située audessus de la seconde zone (5),

f) on soumet à une corrosion isotrope les couches d'oxyde (9, 11) jusqu'à ce que le masque de laque (12) soit soumis à une corrosion sous-jacente, et on met à nu une partie de la surface de la seconde zone (5),

g) on soumet à une corrosion plasmatique la surface du corps semiconducteur, au niveau de la même ouverture (13) du masque de laque (12) jusqu'à ce que l'ouverture (6) soit formée dans la seconde zone (5) et que le renfoncement (7) soit formé dans la première zone (4),

h) on forme la couche (8) conductrice du type n en utilisant le masque de laque (12) et son ouverture (13), au moyen d'une implantation ionique avec une dose $\geqslant 5 \cdot 10^{14}$ atomes cm$^{-2}$,

i) on èlimine par dissolution le masque de laque,

j) on dépose une couche d'aluminium (15) sur les surfaces à nu des première et seconde couches.

## FIG 1

## FIG 2